# EUROPEAN PATENT SPECIFICATION

(11) **EP 2 714 397 B1**
(45) Date of publication and mention of the grant of the patent: **23.09.2015**
(21) Application number: 12724646.0
(22) Date of filing: 31.05.2012
(51) Int. Cl.: B32B 27/32

(54) **COMPOUND FILM FOR INDUSTRIAL PACKAGING APPLICATIONS**
VERBUNDFOLIE FÜR INDUSTRIELLE VERPACKUNGSANWENDUNGEN
FILM COMPOSITE POUR APPLICATIONS D'EMBALLAGE INDUSTRIEL

(30) Priority: 31.05.2011 US 201161491425 P
(43) Date of publication of application: 09.04.2014
(73) Proprietor: Valsem Industries SAS, 60190 Lachelle (FR)
(72) Inventor: DAVIET, Jean-François, F-60190 Lachelle (FR); BORDREZ, Denis, F-60880 Le Meux (FR)
(74) Representative: Prugneau, Philippe
(86) International application number: PCT/EP2012/060264
(87) International publication number: WO 2012/164027

(56) References cited:
- US-A1- 2003 049 475

## Description

### Technical field

The present invention relates to a compound film comprising at least a heat-sealable inner layer, a heat-resistant outer layer, and a barrier layer forming a barrier to corrosive gaseous species.

The compound film of the present invention can be used in high barrier packaging applications.

The US military developed in the 1940's compound films to protect its equipment, especially when said equipment had to spend months onboard seafaring ships, hence intensely exposed to the highly corrosive marine air. The original compound films had an outer layer of heat-resistant cotton fabric, an inner layer of extruded polyethylene, heat sealable for air tightness, and a middle layer of thin aluminum foil, providing for a very high barrier to corrosive gaseous species present in the environment. Using heat sealing "tongues", sensitive goods could then be placed into bags made of such compound films, which were then heat sealed. This then innovative technology spread throughout the world at the turn of World War II, as American troops were partaking in the liberation of countries the world over.

The replacement of the cotton fabric by a heat-resistant and mechanically sound, synthetic polymer, namely polyester film (also known as PET, or polyethylene terephthalate), that occurred in Europe in the 1970's, represented a major follow-on innovation. Since then, very little innovation has been seen in this field of industrial-strength packaging, whereas material performance and cost have significantly evolved.

A multilayer film having gas barrier properties, in which a metal or a metal oxide are deposited on a polymer film and usable for a packaging film is known from European patent application No 1 155 818A.

Another multilayer film intended to ensure proper preservation of perishable food or non-food products, comprising a metallizable polymer layer on which a metal layer is deposited to form a barrier against transmission of air, moisture or flavors, is known from International Patent application No WO 2010147703.

Document US 2003/049475 discloses a polyolefinic multilayer film comprising a core layer of polypropylene and at least one outer layer. Such film does not distort in the presence of food oils.

The primary issue of the traditional industrial grade packaging material is the mix of hydrocarbon polymers, and of a solid aluminum layer, making the compound's recyclability challenging. While cost is always a driver, environmental concerns have recently taken the forefront of the stage in the packaging world as well, in particular since the realization of the global warming phenomenon in the 1990's. The reduction of the hydrocarbon footprint of any human activities is now an important parameter in the design of new products and services. With respect to packaging material, this translates into a thrive toward lighter, thinner, and more recyclable products, while preserving mechanical strength, low permeability, and excellent heat sealability.

Another problem of the traditional packaging compound films is represented by their substantial weight and thickness. Both are linked primarily to the need of mechanical strength, which has historically been addressed by rather thick layers of polymer both on the outer, non-stick, heat resistant layer, and on the inner, heat sealable layer. The barrier layer made of solid, thick aluminum (10-15µm) does contribute to the weight as well, due to the much higher density of the metal compared to the hydrocarbon polymers. Even if the thickness of a massive aluminum layer could be reduced to diminish the weight of the compound film, it is known that below 15µm the quantity of the reputedly unavoidable manufacturing process-induced pinholes, and of compound film handling cracks in said solid aluminum layer, dramatically reduces the actual operational effectiveness of the barrier. It is not uncommon for instance that the permeability of the compound film degrades by two or three orders of magnitude higher when flexed and creased, which is often normal during industrial bagging operations.

It has further been noticed that no known metallized polymers commercially available exhibit by themselves improved barrier properties against oxygen and water vapor, the two major corrosion-generating gases, the latter being the most troublesome in industrial packaging.

### Summary of the invention

The object of the present invention is to solve the above-mentioned problems by providing a low environmental impact compound film adapted for high barrier packaging applications comprising less metal for improved recyclability, being substantially lighter, thinner, stronger, impervious than previously known compound films, and having excellent mechanical strength for similar or lower cost.

The object of the present invention is achieved by a compound film of the kind described in preamble, characterized in that the barrier layer comprises at least one primary barrier layer and at least one secondary barrier layer, said primary barrier layer comprising a polypropylene film on which a layer of a material selected from the group consisting of a metal, a metal oxide, or a silicon oxide is deposited, and said secondary barrier layer comprising a material selected from the group consisting of a metal, a metal-containing material, a metal oxide-containing material or a silicon oxide-containing material.

According to preferable embodiments, said polypropylene film of said primary barrier layer can be in the form of oriented polypropylene ("OPP"), of bi-oriented polypropylene ("BOPP"), or of cast polypropylene ("CPP") which thickness is comprised between 5µm and 60µm, whereas the thickness of the material deposited on the polypropylene film is preferably less than 1µm.

According to the invention, said secondary barrier layer can comprise an approximately 5µm to 25µm thick polymer film, which can consist of polypropylene or polyethylene terephthalate ("PET"), on which a layer of a metal, a metal oxide, or a silicon oxide is deposited. In this case, the thickness of the metal, the metal oxide, or the silicon oxide deposited on said polymer film is preferably less than 1µm. Alternatively, said secondary barrier layer can advantageously comprise said heat-resistant outer layer.

According to another embodiment of the invention, said secondary barrier layer can be a solid aluminum layer, which thickness can be less than 7µm, or a solid or deposited copper layer.

According to further embodiments, a compound film of the present invention can comprise two or more secondary barrier layers.

Preferably, said inner layer is made of a heat-sealable polymeric material selected from the group consisting of polyethylene ("PE"), or ethyl vinyl acetate ("EVA").

Furthermore, said heat-resistant outer layer can be made of polyethylene terephthalate ("PET").

A compound film according to the present invention can also be characterized in that said heat-sealable inner layer, said heat-resistant outer layer, said at least one primary barrier layer and said at least one secondary barrier layer are be bound together by lamination with an adhesive or by hot polymer extrusion, with or without an adhesion primer.

According to another embodiment of the invention, the compound film can comprise at least one reinforcement layer selected from the group consisting of a mesh, a fabric, or a non-woven product.

In this case, said reinforcement layer can be bound to the compound film with an adhesive or with a hot extruded polymeric material selected from the group consisting of polyethylene ("PE"), or ethyl vinyl acetate ("EVA").

Advantageously, said inner layer can be loaded with at least one active additive selected from the group consisting of a desiccant, a hygroscopic material, an anti-static agent, a gliding agent, a volatile corrosion inhibitor ("VCI"), an anti-bacterial compound, copper particulates, or a corrosion-preventing agent.

### Brief description of the drawings

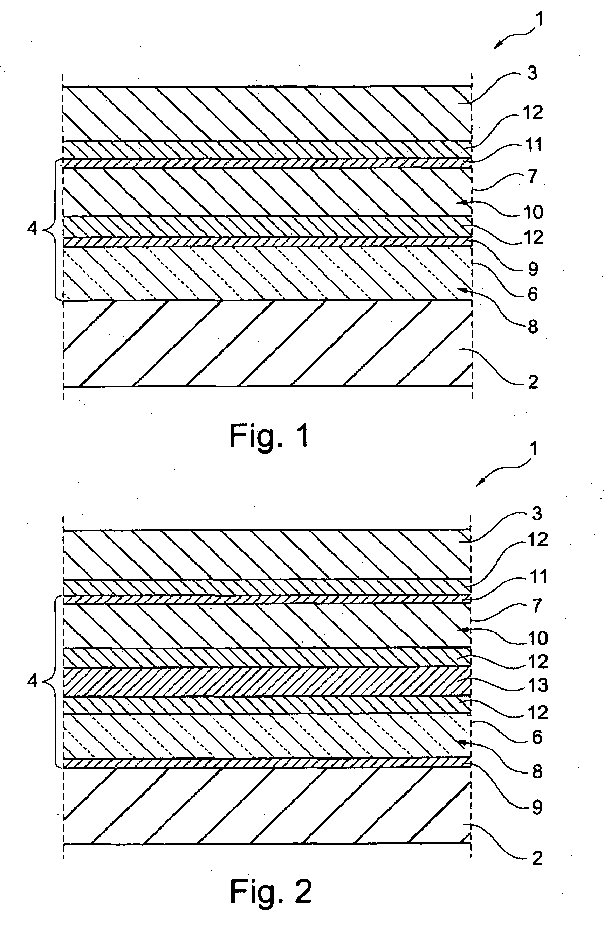

Other aspects of the present invention will become apparent to one of ordinary skill upon consideration of the following description and reference to the attached drawings in which figures 1 to 10 illustrate, in transverse cross section, different constructions of a compound film according to the present invention.

### Detailed description

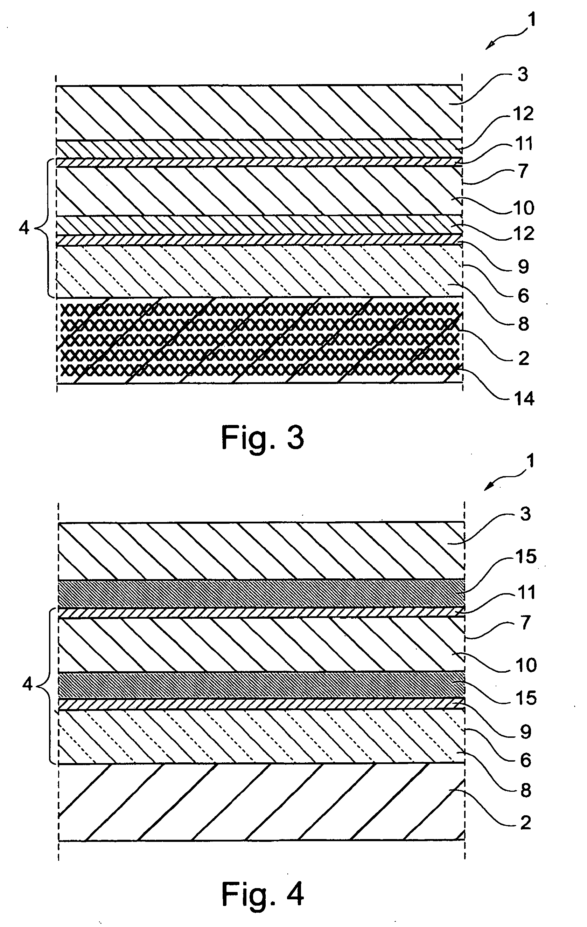

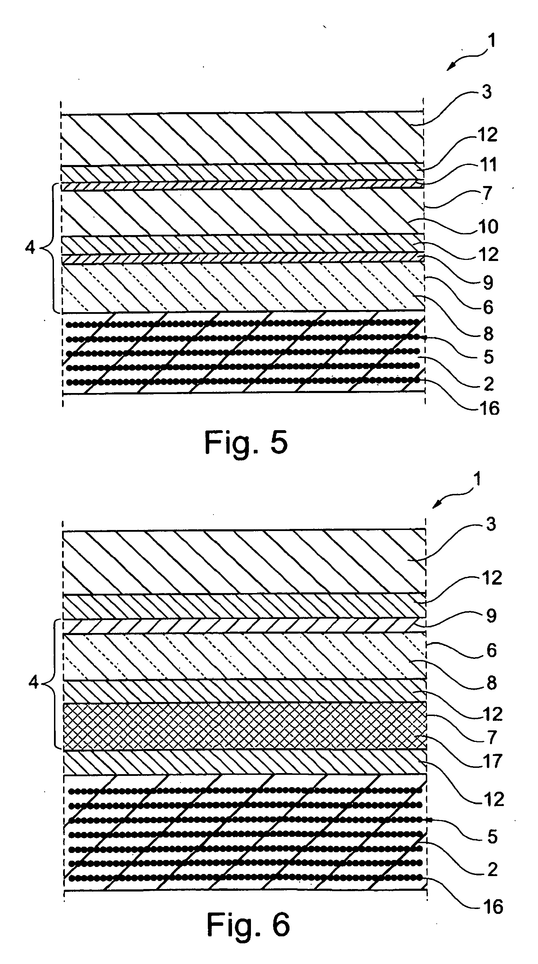

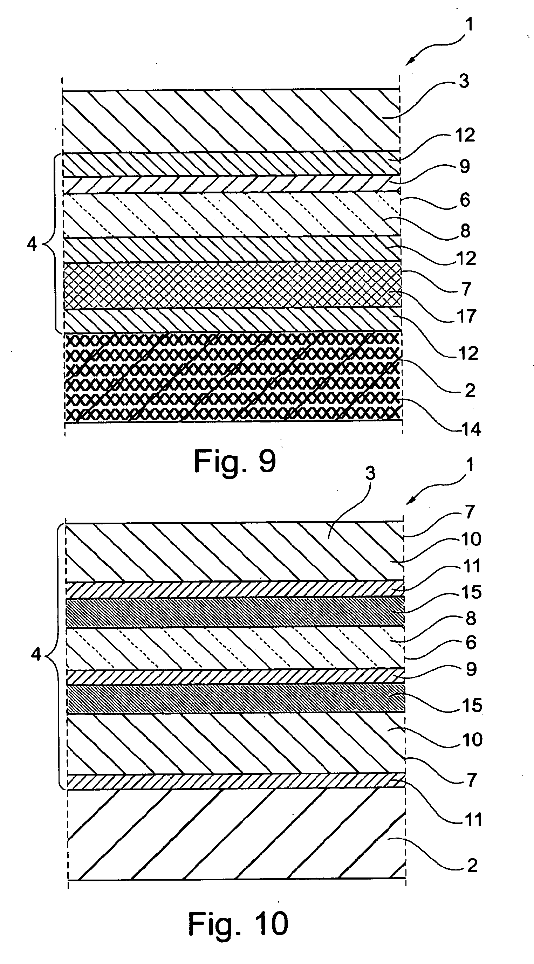

Referring to the drawings, a compound film 1 of the present invention comprises an inner layer 2, made of a heat sealable polymeric material such as, for example, polyethylene ("PE"), ethyl vinyl acetate ("EVA"), or any similar heat-sealable material ensuring air tightness of compound film 1. The thickness of the heat sealable inner layer 2 is preferably chosen between 20µm and 100µm. According to the invention, the inner layer 2 can be loaded or coated with at least one active additive 5 (see fig. 5 and fig. 6), such as for example a desiccant, a hygroscopic material, an anti-static agent, a gliding agent, a volatile corrosion inhibitor ("VCI"), an anti-bacterial compound, copper particulates, or a corrosion-preventing agent. The presence in the inner layer 2 of an additive such as, for example, a volatile corrosion inhibitor ("VCI") contributes advantageously to added corrosion protection of metallic parts which can be comprised in some products intended to be wrapped in the compound film 1. The inner layer 2 can further comprise a reinforcement material selected from the group consisting of a mesh, a fabric, or a non-woven product as illustrated in fig. 3 and fig. 9. In other embodiments, such a reinforcement material can also represent an additive layer, bound to the compound film 1 with a hot extruded polymeric material such as for example polyethylene ("PE"), or ethyl vinyl acetate ("EVA"), or similar.

The compound film 1 further comprises a heat-resistant outer layer 3, made of a material having a significantly higher melting temperature than the inner layer 2, in order to allow an easy heat sealing process of compound film 1. Outer layer 3 is about 12µm thick and is preferably made of a material such as polyethylene terephthalate ("PET") or any similar heat-resistant material.

According to the invention, the compound film 1 further comprises a barrier layer 4 intended to replace the thick, solid aluminum layer of compound films known from the state of the art. Referring to the drawings, the barrier layer 4 comprises at least one primary barrier layer 6, made by a material adapted to provide for a water vapor barrier and at least one secondary barrier layer 7 made by a material adapted to provide for an oxygen or water vapor barrier. The primary barrier layer 6 comprises preferably a polypropylene film 8, in the form, for example, of oriented polypropylene ("OPP"), of bi-oriented polypropylene ("BOPP"), or of cast polypropylene ("CPP"), on which a layer 9 of a material selected from the group consisting of a metal, a metal oxide, or a silicon oxide is deposited. Layer 9 is preferably thinner than 1µm. On the other hand, secondary barrier layer 7 comprises preferably a material such as a thin, solid aluminum layer having a thickness less than 7µm, a solid or deposited copper layer, or a polymer film, for example polyethylene terephthalate ("PET") or any similar polymer, on which a preferably less than 1µm thick layer of a metal, a metal oxide, or a silicon oxide is deposited. The added benefit of such a dual barrier layer 4, is that if one of the primary layer 6 or secondary layer 7 shows a weak spot, such as a crack, the other layer 6, 7 in the line-of-sight will block the corroding species sufficiently well to provide an overall satisfactory barrier layer 4.

In the embodiment as illustrated in fig.1 or fig. 4, the barrier layer 4 comprises a primary barrier layer 6 made of an approximately 30µm thick polypropylene film 8 on which a layer 9 of a metal, a metal oxide, or a silicon oxide is deposited, and a secondary barrier layer 7 made by an approximately 12µm thick polypropylene or polyethylene terephthalate ("PET") film 10 on which a layer 11 of a metal, a metal oxide, or a silicon oxide is deposited. In fig. 1, said heat-sealable inner layer 2, heat-resistant outer layer 3, primary barrier layer 6 and secondary barrier layer 7 are bound together by lamination with an approximately 2µm thick adhesive payer 12. In fig. 4, said heat-sealable inner layer 2, heat-resistant outer layer 3, primary barrier layer 6 and secondary barrier layer 7 are bound together by hot polymer extrusion with an approximately 10µm thick extruded polymer adhesion layer 15.

In fig. 2, which is a variation of the embodiment illustrated in fig. 1, the barrier layer 4 is featuring an approximately 6µm third barrier layer of solid aluminum 13 contributing to enhanced barrier properties against gaseous species.

In fig. 3, which is also a variation of the embodiment illustrated in fig. 1, the inner layer 2 comprises an embedded reinforcement material such as a mesh 14 or similar contributing to enhanced mechanical properties of compound film 1.

The embodiment illustrated in fig. 5 is another variation of the embodiment of fig. 1 where the inner layer 2 comprises an additive such as a volatile corrosion inhibitor ("VCI") 16 or similar, which contributes to added corrosion protection of metallic parts, as previously mentioned.

In the embodiment illustrated in fig. 6 the polypropylene film 8 of the primary barrier layer 6 is approximately 25µm thick and the secondary barrier layer 7 is made of an approximately 6µm thick solid aluminum foil 17. The inner layer 2 comprises an additive such as a volatile corrosion inhibitor ("VCI") 16 or similar, which contributes to added corrosion protection of metallic parts, as previously mentioned.

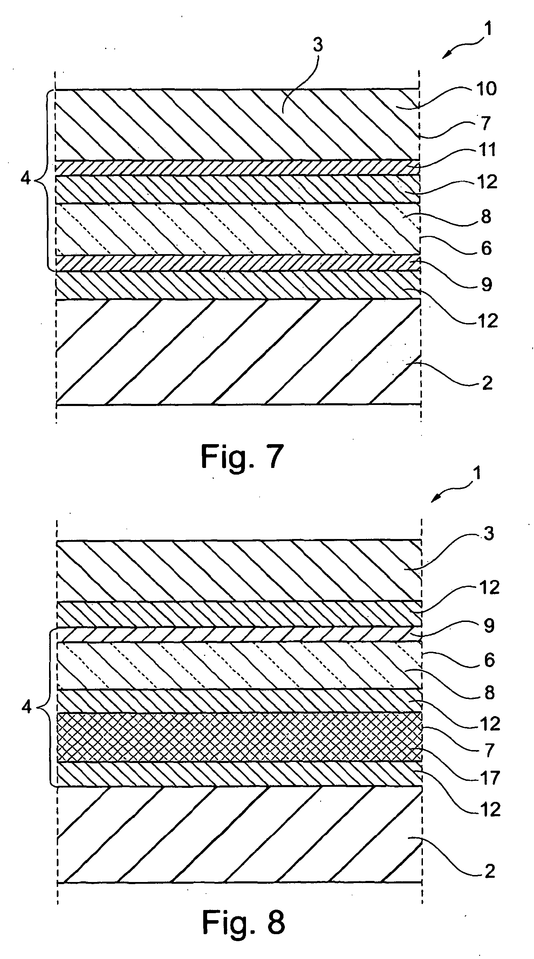

In the embodiment illustrated in fig. 7 the polypropylene film 8 of the primary barrier layer 6 is approximately 25µm thick and the secondary barrier layer 7 is made of an approximately 12µm thick polypropylene or polyethylene terephthalate ("PET") film 10 on which a layer 11 of a metal, a metal oxide, or a silicon oxide is deposited and which comprises the heat-resistant outer layer 3.

The embodiment illustrated in fig. 8 is a variation of the embodiment of fig. 6, in which the heat-sealable inner layer 2 is free of any additives.

The embodiment illustrated in fig. 9 is another variation of the embodiment illustrated in fig. 6, in which the heat-sealable inner layer 2 comprises an embedded reinforcement mesh 14 or similar contributing to enhanced mechanical properties of compound film 1.

In the embodiment as illustrated in fig. 10, the polypropylene film 8 of the primary barrier layer 6 is approximately 25µm thick. The secondary barrier layer 7 is made by an approximately 12µm thick polypropylene or polyethylene terephthalate ("PET") film 10 on which a layer 11 of a metal, a metal oxide, or a silicon oxide is deposited and comprises the heat-resistant outer layer 3. An additional barrier layer 7 made by an approximately 12µm thick polypropylene or polyethylene terephthalate ("PET") film 10 on which a layer 11 of a metal, a metal oxide, or a silicon oxide is deposited, is bound to the compound film 1. Said heat-sealable inner layer 2, heat-resistant outer layer 3, primary barrier layer 6 and secondary barrier layer 7 are bound together by hot polymer extrusion with an approximately 10µm thick extruded polymer adhesion layer 15. This embodiment contributes to added protection against gaseous species.

The presence in a compound film 1 of a barrier layer 4 featuring at least a primary barrier layer 6 and a secondary barrier layer 7 provides a very suitable alternative to the solid, thick aluminum layer contained in previously known compound films. The structures of the various embodiments of fig. 1-10 result in compound films 1 that are, compared to the current generation commercially available from applicant and other fellow manufacturers, at least 30% lighter, 30% thinner, 30% stronger, 30% more impervious, for similar or lower cost. The amount of contained aluminum having been reduced from a factor of about two to about hundred folds compared to traditional compound films, the present invention contributes also for improved recyclability of the present compound film 1. Moreover, the materials forming the primary barrier layer 6 and the secondary barrier layer 7 have very good mechanical properties that are further enhanced by the fact they are bound together.

While there have been described several embodiments of the invention, those skilled in the art will realize that various changes and modifications may be made to the invention without departing from the spirit of such invention. It may for example be suitable to add one or more extra layer to the compound film 1, in order to enhance certain key performance factors, such as mechanical strength or permeability. All such changes and modifications which fall within the scope of the invention are therefore intended to be claimed.

## Claims

1. A compound film (1) comprising at least a heat-sealable inner layer (2), a heat-resistant outer layer (3), and a barrier layer (4) forming a barrier to corrosive gaseous species, **characterized in that** the barrier layer (4) comprises at least one primary barrier layer (6) and at least one secondary barrier layer (7), said primary barrier layer (6) comprising a polypropylene film (8) on which a layer (9) of a material selected from the group consisting of a metal, a metal oxide, or a silicon oxide is deposited, and said secondary barrier layer (7) comprising a material selected from the group consisting of a metal, a metal-containing material, a metal oxide-containing material or a silicon oxide-containing material.

2. A compound film (1) according to claim 1, **characterized in that** said polypropylene film (8) of said primary barrier layer (6) is in the form of oriented polypropylene ("OPP"), of bi-oriented polypropylene ("BOPP"), or of cast polypropylene ("CPP").

3. A compound film (1) according to claim 1, **characterized in that** the thickness of the polypropylene film (8) is comprised between 5µm and 60µm, whereas the thickness of the material (9) deposited on the polypropylene film (8) is less than 1µm.

4. A compound film (1) according to claim 1, **characterized in that** said secondary barrier layer (7) comprises a polymer film (10) on which a layer (11) of a metal, a metal oxide, or a silicon oxide is deposited.

5. A compound film (1) according to claim 4, **characterized in that** said polymer film (10) of said secondary barrier layer (7) consists of polypropylene or polyethylene terephthalate ("PET").

6. A compound film (1) according to claim 4, **characterized in that** the thickness of the polypropylene or polyethylene terephthalate ("PET") layer is about 5µm to 25µm thick, whereas the thickness of the metal, the metal oxide, or the silicon oxide deposited on said polymer film (10) is less than 1µm.

7. A compound film (1) according to claim 1, **characterized in that** said secondary barrier layer (7) comprises said heat-resistant outer layer (3).

8. A compound film (1) according to claim 1, **characterized in that** said secondary barrier layer (7) is a solid aluminum layer (17), or a solid or deposited copper layer.

9. A compound film (1) according to claim 8, **characterized in that** the thickness of said solid aluminum layer (17) is less than 7µm.

10. A compound film (1) according to claim 1, **characterized in that** it comprises two or more secondary barrier layers (7).

11. A compound film (1) according to claim 1, **characterized in that** said inner layer (2) is made of a heat-sealable polymeric material selected from the group consisting of polyethylene ("PE"), or ethyl vinyl acetate ("EVA").

12. A compound film (1) according to claim 1, **characterized in that** said heat-resistant outer layer (3) is made of polyethylene terephthalate ("PET").

13. A compound film (1) according to claim 1, **characterized in that** said heat-sealable inner layer (2), said heat-resistant outer layer (3), said at least one primary barrier layer (6) and said at least one secondary barrier layer (7) are bound together by lamination with an adhesive (12) or by hot polymer extrusion, with or without an adhesion primer (15).

14. A compound film (1) according to claim 1, **characterized in that** it comprises at least one reinforcement layer selected from the group consisting of a mesh (14), a fabric, or a non-woven product.

15. A compound film (1) according to claim 14, **characterized in that** said reinforcement layer is bound to the compound film (1) with a hot extruded polymeric material selected from the group consisting of polyethylene ("PE"), or ethyl vinyl acetate ("EVA")

16. A compound film (1) according to claim 1, **characterized in that** said inner layer (2) is loaded or coated with at least one active additive (5) selected from the group consisting of a desiccant, a hygroscopic material, an anti-static agent, a gliding agent, a volatile corrosion inhibitor ("VCI") (16), an anti-bacterial compound, copper particulates, or a corrosion-preventing agent.

## Patentansprüche

1. Verbundfolie (1), umfassend
zumindest eine heißsiegelfähige innere Schicht (2),
eine hitzebeständige äußere Schicht (3), und
eine Barriereschicht (4), welche eine Barriere zu korrosiven Gasarten bildet,
**dadurch gekennzeichnet,**
**dass** die Barriereschicht (4) zumindest eine primäre Barriereschicht (6) und zumindest eine sekundäre Barriereschicht (7) umfasst, wobei die primäre Barriereschicht (6) eine Polypropylenfolie (8) umfasst, auf welcher eine Schicht (9) aus einem Material, ausgewählt aus der Gruppe, umfassend ein Metall, ein Metalloxid oder Siliziumoxid, aufgebracht ist, und wobei die sekundäre Barriereschicht (7) aus einem Material, ausgewählt aus einer Gruppe, umfassend ein Metall, ein metallhaltiges Material, ein metalloxidhaltiges Material oder ein siliziumoxidhaltiges Material, besteht.

2. Verbundfolie (1) nach Anspruch 1, **dadurch gekennzeichnet, dass** die Polypropylenfolie (8) der primären Barriereschicht (6) in Form von orientiertem Polypropylen ("OPP"), bi-orientiertem Polypropylen ("BOPP") oder ungerecktem Polypropylen ("CPP") vorliegt.

3. Verbundfolie (1) nach Anspruch 1, **dadurch gekennzeichnet, dass** die Dicke der Polypropylenfolie (8) zwischen 5 µm und 60 µm beträgt, wohingegen die Dicke des Materials (9), welches auf der Polypropylenfolie (8) aufgebracht ist, weniger als 1 µm beträgt.

4. Verbundfolie (1) nach Anspruch 1, **dadurch gekennzeichnet, dass** die sekundäre Barriereschicht (7) eine Polymerfolie (10) umfasst, auf welcher eine Schicht (11) aus einem Metall, einem Metalloxid oder einem Siliziumoxid aufgebracht ist.

5. Verbundfolie (1) nach Anspruch 4, **dadurch gekennzeichnet, dass** die Polymerfolie (10) der sekundären Barriereschicht (7) aus Polypropylen oder Polyethylenterephthalat ("PET") besteht.

6. Verbundfolie (1) nach Anspruch4, **dadurch gekennzeichnet, dass** die Dicke der Polyproylen- oder Polyethylenterephthalat ("PET") -schicht etwa zwischen 5 µm und 25 µm beträgt, wohingegen die Dicke des Metalls, des Metalloxids oder des Siliziumoxids, welches auf der Polymerfolie (10) aufgebracht ist, weniger als 1 µm beträgt.

7. Verbundfolie (1) nach Anspruch 1, **dadurch gekennzeichnet, dass** die sekundäre Barriereschicht (7) die hitzebeständige äußere Schicht (3) umfasst.

8. Verbundfolie (1) nach Anspruch 1, **dadurch gekennzeichnet, dass** die sekundäre Barriereschicht (7) eine massive Aluminiumschicht (17) oder eine massive oder abgeschiedene Kupferschicht ist.

9. Verbundfolie (1) nach Anspruch 8, **dadurch gekennzeichnet, dass** die Dicke der massiven Aluminiumschicht (17) weniger als 7 µm beträgt.

10. Verbundfolie (1) nach Anspruch 1, **dadurch gekennzeichnet, dass** diese zwei oder mehr sekundäre Barriereschichten (7) umfasst.

11. Verbundfolie (1) nach Anspruch 1, **dadurch gekennzeichnet, dass** die innere Schicht (2) aus einem heißsiegel-fähigem Polymermaterial, ausgewählt aus der Gruppe, umfassend ein Polyethylen ("PE") oder Ethylvinylacetat ("EVA"), hergestellt ist.

12. Verbundfolie (1) nach Anspruch 1, **dadurch gekennzeichnet, dass** die hitzebeständige äußere Schicht (3) aus Polyethylenterephthalat ("PET") hergestellt ist.

13. Verbundfolie (1) nach Anspruch 1, **dadurch gekennzeichnet, dass** die heißsiegelfähige innere Schicht (2), die hitzebeständige äußere Schicht (3), die zumindest eine primäre Barriereschicht (6) und die zumindest eine sekundäre Barriereschicht (7) durch Laminierung mittels eines Klebers (12) oder heißer Polymerextrusion mit oder ohne Haftvermittler (15) verbunden sind.

14. Verbundfolie (1) nach Anspruch 1, **dadurch gekennzeichnet, dass** diese zumindest eine Bewehrungslage umfasst, die ausgewählt ist aus der Gruppe, umfassend ein Geflecht (14), ein Gewebe oder ein Vließ.

15. Verbundfolie (1) nach Anspruch 14, **dadurch gekennzeichnet, dass** die Bewehrungslage mit der Verbundfolie (1) mittels eines heiß extrudierten Polymermaterials, ausgewählt aus der Gruppe, umfassend Polyethylen ("PE") oder Ethylvinylacetat ("EVA"), verbunden ist.

16. Verbundfolie (1) nach Anspruch 1, **dadurch gekennzeichnet, dass** die innere Schicht (2) mit zumindest einem aktiven Additiv (5), ausgewählt aus der Gruppe, umfassend ein Trockenmittel, ein hygroskopisches Material, ein Antistatikum, ein Gleitmittel, einen flüchtigen Korrosionsinhibitor ("VCI") (16), ein antibakterielles Präparat, Kupferpartikel oder ein Antikorrosionsmittel, beladen oder beschichtet ist.

## Revendications

1. Film composite (1) comprenant au moins une couche interne (2) soudable à chaud, une couche externe (3) résistante à la chaleur, et une couche barrière (4) formant une barrière aux espèces gazeuses corrosives, **caractérisé en ce que** la couche barrière (4) comprend au moins une couche barrière primaire (6) et au moins une couche barrière secondaire (7), ladite couche barrière primaire (6) comprenant un film de polypropylène (8) sur lequel une couche (9) en un matériau choisi parmi le groupe constitué par un métal, un oxyde métallique ou un oxyde de silicium est déposé, et ladite couche barrière secondaire (7) comprenant un matériau choisi dans le groupe constitué par un métal, un matériau contenant du métal, un matériau métallique contenant de l'oxyde ou un matériau contenant de l'oxyde de silicium.

2. Film composite (1) selon la revendication 1, **caractérisé en ce que** ledit film de polypropylène (8) de ladite couche barrière primaire (6) est sous la forme de polypropylène orienté ("OPP"), de polypropylène bi-orienté ("BOPP"), ou de polypropylène coulé ("PPC").

3. Film composite (1) selon la revendication 1, **caractérisé en ce que** l'épaisseur du film de polypropylène (8) est comprise entre 5µm et 60µm, tandis que l'épaisseur du matériau (9) déposé sur le film de polypropylène (8) est inférieure à 1 µm.

4. Film composite (1) selon la revendication 1, **caractérisé en ce que** ladite couche barrière secondaire (7) comprend un film de polymère (10) sur lequel une couche de métal (11), d'oxyde métallique, ou d'oxyde de silicium, est déposée.

5. Film composite (1) selon la revendication 4, **caractérisé en ce que** ledit film de polymère (10) de ladite couche barrière secondaire (7) se compose de polypropylène ou de polyéthylène téréphtalate ("PET").

6. Film composite (1) selon la revendication 4, **caractérisé en ce que** l'épaisseur de la couche de polypropylène ou du polyéthylène téréphtalate ("PET") est épais d'environ de 5µm à 25µm, tandis que l'épaisseur du métal, de l'oxyde métallique, ou de l'oxyde de silicium déposé sur ledit film de polymère (10) est inférieure à 1µm.

7. Film composite (1) selon la revendication 1, **caractérisé en ce que** ladite couche barrière secondaire (7) comprend ladite couche externe (3) résistante à la chaleur.

8. Film composite (1) selon la revendication 1, **caractérisé en ce que** ladite couche barrière secondaire (7) est une couche d'aluminium solide (17), ou une couche de cuivre déposée ou solide.

9. Film composite (1) selon la revendication 8, **caractérisé en ce que** l'épaisseur de ladite couche d'aluminium solide (17) est inférieure à 7µm.

10. Film composite (1) selon la revendication 1, **caractérisé en ce qu'**il comprend deux ou plusieurs couches barrière secondaire (7).

11. Film composite (1) selon la revendication 1, **caractérisé en ce que** ladite couche interne (2) est réalisée en un matériau polymère thermo-soudable choisi dans le groupe constitué par du polyéthylène ("PE"), ou d'éthyle vinyle acétate ("EVA").

12. Film composite (1) selon la revendication 1, **caractérisé en ce que** ladite couche extérieure résistante à la chaleur (3) est réalisée en polyéthylène téréphtalate ("PET").

13. Film composite (1) selon la revendication 1, **caractérisé en ce que** ladite couche interne soudable à chaud (2), ladite couche externe résistante à la chaleur (3), ladite au moins une couche barrière primaire (6) et ladite au moins une couche barrière secondaire (7) sont liées ensemble par stratification avec un adhésif (12) ou par extrusion à chaud du polymère, avec ou sans une adhérence primaire (15).

14. Film composite (1) selon la revendication 1, **caractérisé en ce qu'**il comprend au moins une couche de renfort choisie dans le groupe constitué d'un treillis (14), un tissu ou un produit non-tissé.

15. Film composite (1) selon la revendication 14, **caractérisé en ce que** ladite couche de renforcement est liée au film composite (1) avec un matériau polymère extrudé à chaud choisi dans le groupe constitué par du polyéthylène ("PE"), ou d'éthyle vinyle acétate ("EVA").

16. Film composite (1) selon la revendication 1, **caractérisé en ce que** ladite couche interne (2) est chargée ou revêtue d'au moins un additif actif (5) choisi dans le groupe constitué d'un agent déshydratant, d'un matériau hygroscopique, un agent antistatique, un agent glissant, un inhibiteur volatil de corrosion ("VCI") (16), un composé antibactérien, de particules de cuivre, ou un agent de prévention de la corrosion.
